## Europäisches Patentamt
## European Patent Office
## Office européen des brevets

(19)

(11) Numéro de publication: **0 227 125**
**B1**

(12)

# FASCICULE DE BREVET EUROPEEN

(45) Date de publication du fascicule du brevet:
13.09.89

(51) Int. Cl.⁴: **C30B 19/06, C30B 29/48**

(21) Numéro de dépôt: **86201816.5**

(22) Date de dépôt: **20.10.86**

(54) Creuset pour l'épitaxie en phase liquide de couches semiconductrices.

(30) Priorité: **22.10.85 FR 8515654**

(43) Date de publication de la demande:
**01.07.87 Bulletin 87/27**

(45) Mention de la délivrance du brevet:
**13.09.89 Bulletin 89/37**

(84) Etats contractants désignés:
**DE FR GB IT NL**

(56) Documents cités:
**FR-A- 2 228 302**
**FR-A- 2 557 154**
**US-A- 3 925 117**

(73) Titulaire: **LABORATOIRES D'ELECTRONIQUE ET DE PHYSIQUE APPLIQUEE L.E.P., 3, Avenue Descartes, F-94450 Limeil-Brévannes(FR)**
(84) Etats contractants désignés: **FR**

(73) Titulaire: **N.V. Philips' Gloeilampenfabrieken, Groenewoudseweg 1, NL-5621 BA Eindhoven(NL)**
(84) Etats contractants désignés: **DE GB IT NL**

(72) Inventeur: **Latorre, Bernard Société Civile S.P.I.D., 209, rue de l'Université, F-75007 Paris(FR)**
Inventeur: **Martin, Guy Société Civile S.P.I.D., 209, rue de l'Université, F-75007 Paris(FR)**

(74) Mandataire: **Landousy, Christian et al, Société Civile S.P.I.D. 209, Rue de l'Université, F-75007 Paris(FR)**

ACTORUM AG

## Description

L'invention concerne un creuset pour la croissance de couches épitaxiales, de composés chimiques formés de plusieurs éléments chimiques, par la méthode d'épitaxie en phase liquide, comprenant une embase allongée sur laquelle une partie mobile glisse longitudinalement, l'embase comprenant au moins un logement dans lequel est placé un élévateur maintenu en position à l'aide d'une légère force développée par un système de pression, élévateur sur lequel est placé un substrat sur lequel se dépose au moins une couche épitaxiale, la partie mobile comprenant au moins une cavité, recevant une source mère formée de matériaux initiaux d'épitaxie, la cavité présentant, sur la face qui jouxte l'embase, une ouverture inférieure dont les dimensions sont en rapport avec les dimensions des substrats qui y sont présentés, le creuset étant destiné à être disposé dans un réacteur porté à une température d'épitaxie.

Une invention de ce genre est connue du brevet US 4 366 771.

Il est connu d'après ce document de réaliser des couches de $Hg_{1-x} Cd_x Te$ dans un creuset de graphite constitué de deux blocs dont un premier bloc est traversé par des cavités pouvant recevoir différentes compositions de sources, ce premier bloc étant mobile par rapport à un second bloc recevant le substrat. L'ensemble du creuset est placé dans un four tubulaire où circule un flux d'hydrogène.

Le second bloc reçoit le substrat dans un logement qui y est ménagé de telle sorte que le substrat affleure du second bloc. Les épaisseurs des substrats utilisés successivement doivent dont être calibrées en fonction de la profondeur donnée à ce logement.

L'épitaxie est effectuée typiquement à une température de 450°C à 500°C pour des solutions mères riches en tellure. Lorsque le temps nécessaire est écoulé, le substrat avec so couche épitaxiale est séparé de la solution liquide par un mouvement de translation. La construction du creuset est telle que la couche épitaxiale est ainsi "essuyée" laissant l'état de surface plus ou moins correct selon la construction du creuset et la nature des constituants de la couche. L'épaisseur des couches est tributaire du jeu qui existe entre le niveau supérieur du substrat et le bloc mobile contenant les solutions mères.

Mais dans le cas de la croissance de couches épitaxiales de $Hg_{1-x} Cd_x Te$ des difficultés apparaissent à cause de la forte pression partielle du mercure comparée à celle du cadmium et du tellure. La source mère à tendance à s'appauvrir en mercure et une composition constante des couches épitaxiales n'est plus correctement assurée.

Afin de remédier à ce problème, le document US 4 366 771 décrit un creuset dans lequel les cavités de croissance communiquent avec une source de mercure. Ces cavités traversent le premier bloc mobile et sont entourées sur les deux faces de petites rainures peu profondes réunies entre elles sur les faces respectivement supérieure et inférieure par un prolongement des rainures et entre les deux faces par un trou pratiqué dans le premier bloc mobile, trou situé à l'écart des cavités. En fonctionnement, un bouchon est placé à la partie supérieure de la cavité pour en obstruer l'ouverture. L'apport de Hg s'effectue donc principalement de la partie supérieure vers la partie inférieure du premier bloc à travers ledit trou de sorte que l'apport supplémentaire de vapeurs de mercure s'effectue au niveau de la couche épitaxiale afin de rendre minimale la perte de mercure.

Après la réalisation de la première couche le substrat peut ensuite être mis en contact avec une seconde source pour obtenir une seconde couche de propriétés différentes.

Mais il n'est pas possible selon cette technique de contrôler correctement l'espace entre la couche terminée et le bloc supérieur, lié à l'épaisseur de la couche, ce qui est un paramètre déterminant pour l'essuyage, ni de s'affranchir des tolérances variables sur les épaisseurs des substrats, à plus forte raison sur les substrats munis déjà de une ou plusieurs couches épitaxiales. Des dépôts multicouches sont donc très difficiles à contrôler et on est vite limité pour effectuer correctement la translation du bloc mobile.

D'autre part, la construction de ce creuset ne permet pas de contrôler d'une façon efficace et reproductible la composition chimique des couches et en particulier la teneur en mercure. Malgré la pression de mercure dans les rainures, pouvant différer légèrement de celle existant au dessus de la solution, le léger espace qui existe entre le premier bloc et le deuxième bloc détermine le flux de mercure échangé entre la source de mercure et la solution. Ce léger espace ne peut être contrôlé d'une opération à une autre.

Un but de l'invention est donc de permettre d'utiliser des substrats dont les tolérances sur les épaisseurs initiales ne soient pas rigoureusement déterminées.

Un autre but est de ne pas rayer la surface de la partie utile de la couche épitaxiale au moment de la translation.

Un autre but est de permettre la réalisation de multicouches d'épaisseurs variables.

Pour cela l'invention telle que définie dans le préambule est remarquable en ce que la partie mobile présente sur toute sa longueur une rainure longitudinale, sur la face qui glisse longitudinalement sur l'embase, cette rainure ayant une profondeur légèrement supérieure aux irrégularités du substrat et suffisamment faible pour que la source mère ne puisse passer par capillarité, et une largeur inférieure aux dimensions du substrat afin que celui-ci ne puisse y pénétrer, et en ce que le substrat est maintenu plaqué sur les bords latéraux de la rainure par l'élévateur.

Le creuset selon l'invention est réalisé préférentiellement en graphite, mais il peut également être réalisé en nitrure de bore, ou en associant le graphite et le quartz. L'élévateur coulisse à frottements doux dans le logement de l'embase. Le substrat, placé sur l'élévateur, vient appuyer sur les deux lèvres de la rainure longitudinale pratiquée dans la partie mobile. Cette rainure a typiquement une pro-

fondeur de 30 μm. Les produits initiaux, tels que Cd, Te et Hg pour la croissance de couches de $Hg_{1-x} Cd_x Te$ sont placés dans une cavité de la partie mobile. Après que le creuset ainsi chargé a été placé dans un four tubulaire en quartz où circule un gaz réducteur tel que l'hydrogène, les produits deviennent liquides à la température d'épitaxie qui est pour ces matériaux de 450°C à 500°C.

Le substrat est maintenu en contact avec les produits initiaux liquides pendant la durée nécessaire au dépôt de l'épaisseur de la couche épitaxiale recherchée par exemple 1/2 heure pour 30 μm. A l'issue de cette durée la partie mobile est déplacée longitudinalement sur l'embase selon la direction de la rainure et l'épitaxie est alors terminée. Lors de cette opération seuls les bords du substrat en contact avec les lèvres de la rainure vont présenter de légères rayures alors que la majeure partie centrale de la couche épitaxiale présente une qualité de surface excellente.

Le substrat, ou lors d'opérations suivantes, la dernière couche épitaxiale, est donc toujours en appui sur les lèvres de la rainure ce qui permet le contrôle du jeu mécanique et donc de la qualité des couches quelle que soit l'épaisseur des substrats utilisés.

Cette force d'appui est développée par un système de pression constitué selon une première variante par un fléau. Celui-ci présente une structure dissymétrique de sorte que par rapport à un axe le traversant, une de ses extrémités va subir l'effet des forces de pesanteur et donc relever l'au tre extrémité qui développe ainsi la force d'appui nécessaire. Ce système de pression est réalisé en totalité dans le même matériau que le creuset par exemple en graphite afin de n'apporter aucune pollution et une tenue excellente aux hautes températures.

Selon une seconde variante le système de pression est constitué par un ressort en matériau réfractaire non métallique constitué d'un tube cylindrique creux muni d'évidements.

Dans la métallurgie des semiconducteurs il est très souvent nécessaire d'effectuer des opérations de mouvement à l'intérieur d'une enceinte fermée dans laquelle règne un certain nombre d'équilibres de pression, de température, de composition chimique. La transmission de mouvement ou de forces s'avère difficile, et ceci bien qu'ils soient généralement de faibles amplitudes.

Pour traiter ce problème, le ressort est réalisé préférentiellement dans un tube de quartz dont la section droite est annulaire. Ce tube présente des évidements réalisés à l'aide d'une scie à fils, par exemple, et qui débouchent dans la partie creuse du tube. Ces évidements sont pratiqués sensiblement selon une section droite, et après avoir traversé la première face de la surface interne du tube cylindrique viennent préférentiellement en effleurer la seconde face.

Des évidements voisins sont placés à une distance e les uns des autres, décalés en rotation par rapport à l'axe du tube cylindrique, de sorte que tous les évidements réalisés dans le tube se succèdent selon une répartition hélicoïdale. Plusieurs évidements sont donc placés sur une même génératrice à une distance T tel que

$$n = \frac{T}{h+e}$$

Sur une distance T, il y a donc n évidements successifs qui sont décalés en rotation d'un angle 360°/n.

Pour réaliser un tel ressort il est préférable d'utiliser une scie multifils dont les fils sont distants de T. On opère ainsi simultanément tous les évidements distants de T. Puis on tourne le tube de quartz sur son support d'un angle 360°/n et on effectue à nouveau tous les évidements distants de T. L'opération est effectuée pour les n rotations.

Le matériau réfractaire non métallique peut être du quartz, du carbone ou du nitrure de bore. Préférentiellement la section droite du tube cylindrique creux est annulaire.

Dans la croissance de couche épitaxiale en phase liquide, les éléments constitutifs du matériau formant la couche épitaxiale présentent des pressions de vapeurs propres, qui dans la plupart des cas sont très différentes. Ainsi, dans le cas de couches de $Hg_{1-x} Cd_x Te$, les pressions partielles propres de chaque élément constitutifs sont pour $x = 0,3$ :

$Cd \approx 10^{-1}$ Pa à 500°C
$Te \approx 10^2$ Pa à 500°C
$Hg \approx 10^4$ Pa à 500°C.

Ceci a pour conséquence que la source liquide va présenter une concentration qui va évoluer dans le temps.

La couche épitaxiale qui se forme à partir d'une telle source à concentration non stabilisée va elle-même présenter une composition qui va évoluer selon son épaisseur. Ceci est préjudiciable à la réalisation de dispositifs semiconducteurs aux propriétés bien définies, stables et reproductibles.

Pour surmonter cette difficulté le creuset comporte une partie mobile dont les cavités sont munies, à leur partie supérieure, d'un réservoir annulaire, destiné à recevoir une composition de l'élément dont la solution liquide mère à tendance à s'appauvrir. Les vapeurs dégagées par ce réservoir annulaire sont en contact avec la solution liquide contenue dans la cavité par l'intermédiaire d'au moins un conduit étroit qui permet de compenser l'appauvrissement de la solution liquide mère par les vapeurs issues du réservoir annulaire.

Le calibrage du conduit est déterminé afin que l'apport de l'élément le plus volatil qu'il fournit compense la perte de ce même élément dans la solution mère, perte qui s'effectue par les fuites existant au niveau de la couche épitaxiale.

Les couches de $Hg_{1-x} Cd_x Te$ sont utilisées pour réaliser des détecteurs infra-rouge opérant dans la gamme de longueurs d'onde de 3 à 5 μm ou de 8 à 12 μm.

L'invention sera mieux comprise à l'aide des dessins suivants, donnés à titre d'exemples non limitatifs, qui représentent :

figure 1 : une vue en coupe d'un creuset selon l'invention avec un élévateur actionné par un fléau,

figure 2 : une vue en coupe du creuset selon l'invention,

figure 3 : une vue de dessous de la partie mobile du creuset,

figure 4 : une vue en coupe d'un creuset selon l'invention avec un élévateur actionné par un ressort en quartz,

figure 5 : une portion de ressort selon l'invention,

figure 6 : une illustration du mécanisme de découpe d'un tube cylindrique creux et du ressort ainsi obtenu selon l'invention avec n = 3,

figure 7 : une coupe, selon l'axe de symétrie du tube, d'un ressort selon l'invention,

figure 8 : une courbe de compression-extension en fonction de la force appliquée.

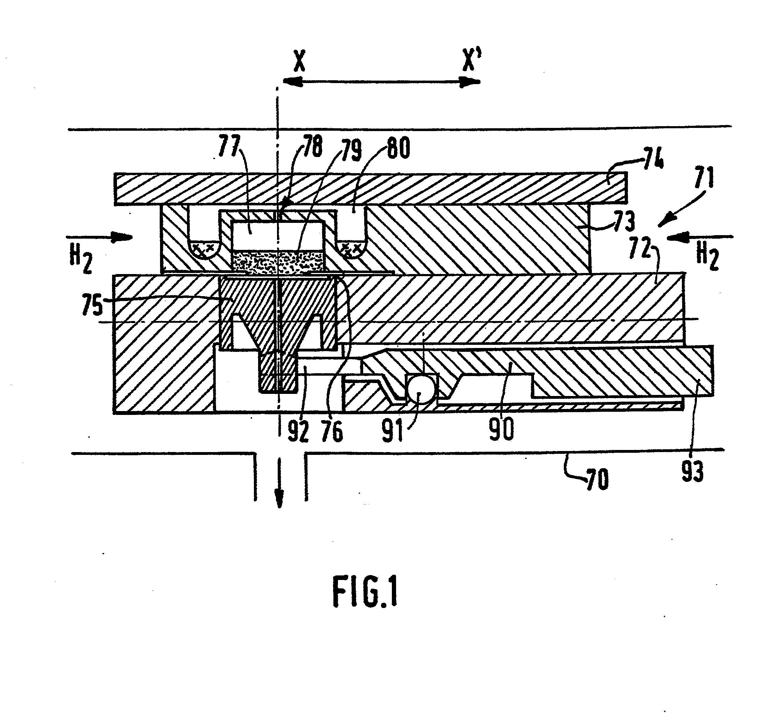

Sur la figure 1 est représenté un four à épitaxie 70, généralement constitué d'un tube de quartz entouré d'enroulements chauffants non représentés. A l'intérieur de ce four est placé un creuset 71 selon l'invention. Il est constitué d'une embase 72, d'une partie mobile 73 est d'un couvercle 74. Ces trois éléments coulissent les uns sur les autres à frottements doux selon la direction XX' qui est l'axe du tube du four d'épitaxie. Ils sont pour cela munis de gorges latérales qui n'autorisent leurs mouvements que dans cette direction.

L'embase 72 est évidée pour laisser passer un élévateur 75 qui peut se déplacer selon une direction sensiblement perpendiculaire à l'embase 72 à l'aide d'une force développée par un système de pression détaillé ci-après. L'élévateur 75 porte un substrat 76, représenté à une échelle plus grande pour la commodité du dessin.

La partie mobile 73 présente une cavité 77, ouverte dans la direction de l'embase 72, mais fermée dans sa partie supérieure à l'exception d'un conduit calibré 78 qui la réunit à un réceptacle préférentiellement annulaire 80 destiné à recevoir des matériaux de croissance à forte tension de vapeurs. La cavité 77 reçoit la solution riche en Te préalablement préparée pour la croissance de couche $Hg_{1-x} Cd_x Te$. A la température d'épitaxie ces matériaux constituent une source mère liquide 79. Le substrat 76 présente une dimension légèrement supérieure à l'ouverture de la cavité 77 afin que celui-ci ne puisse y pénétrer.

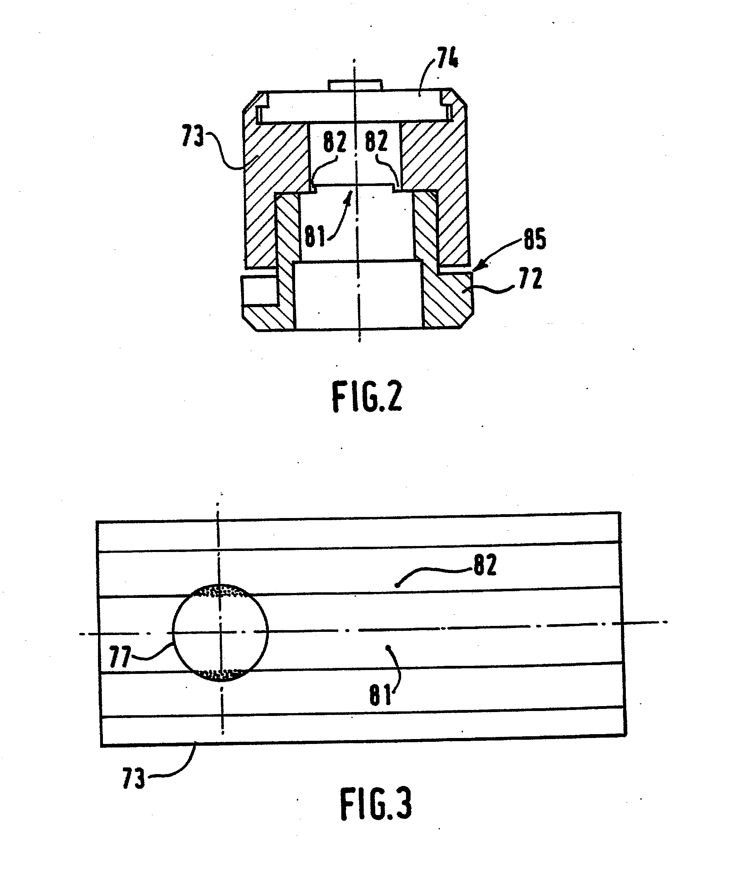

La figure 2 représente une vue en coupe, selon une direction perpendiculaire à la direction XX'. La partie mobile 73 présente sur toute sa longueur et selon XX' une rainure 81 de très faible profondeur. Ainsi le substrat ne peut être en contact avec la partie mobile 73 que par les deux lèvres latérales 82 de la rainure. En effet, lorsque la partie mobile 73 est posée sur l'embase 72 elle ne peut porter que sur les deux lèvres latérales 82 car un jeu 85 existe entre l'embase 72 et la partie mobile 73.

Sur la figure 3 est représentée une vue de dessous de la partie mobile 73. La rainure 81 est légèrement plus petite que la cavité 77 de sorte que les lèvres latérales 82 de la rainure 81 n'existent pas dans la cavité 77. Ainsi lorsque la partie mobile 73 est translatée sur l'embase 72 selon la direction XX', seules les surfaces du substrat 76 qui sont en contact avec les lèvres 82 vont présenter de petites rayures. Ces surfaces sont représentées sur la figure 3 par un pointillé. La majeure partie centrale du substrat 16 reste ainsi intacte.

La profondeur de la rainure 81 est déterminée en premier lieu par la fluidité de la solution mère aux températures d'épitaxie utilisées. En effet, il ne faut pas que par capillarité cette solution mère puisse passer entre l'embase 72 et la partie mobile 73. La rainure doit donc être aussi petite que possible. Une seconde limitation est déterminée par la qualité de l'état de surface du substrat. Un état de surface acceptable est par exemple de ne pouvoir voir qu'une ou deux franges d'interférence pour un substrat de 15 mm de diamètre. Ceci est caractéristique à la fois de l'état de surface et de la planéité du substrat. Pour conserver aux couches réalisées une très bonne qualité de surface, une rainure avec une profondeur de 30 μm a donné satisfaction.

Les tolérances très serrées données au jeu existant entre la partie mobile 73 et l'embase 72, associées à une rainure longitudinale de profondeur constante, font que même si l'embase 72 présente plusieurs postes analogues pour recevoir plusieurs substrats, la qualité de l'état de surface de toutes les couches est assurée.

La figure 1 représente un creuset selon l'invention pour lequel la force de pression est développée par un fléau 90. Ce fléau est excentré par rapport à un axe 91 de sorte que la partie 92 qui est en contact avec l'élévateur subit une force ascendante. Ceci est assuré en donnant à la partie 93 du fléau une masse supérieure à la partie 92 par exemple en intervenant sur sa forme. Ainsi l'élévateur 75 est sollicité vers le haut et plaque le substrat 76 sur les lèvres de la rainure de la partie mobile 73.

Dans le cas d'un creuset présentant plusieurs porte-substrats un fléau unique peut actionner simultanément tous les postes à l'aide d'un système de palonnier qui répartit de façon égale la force globale de pression produite par le fléau.

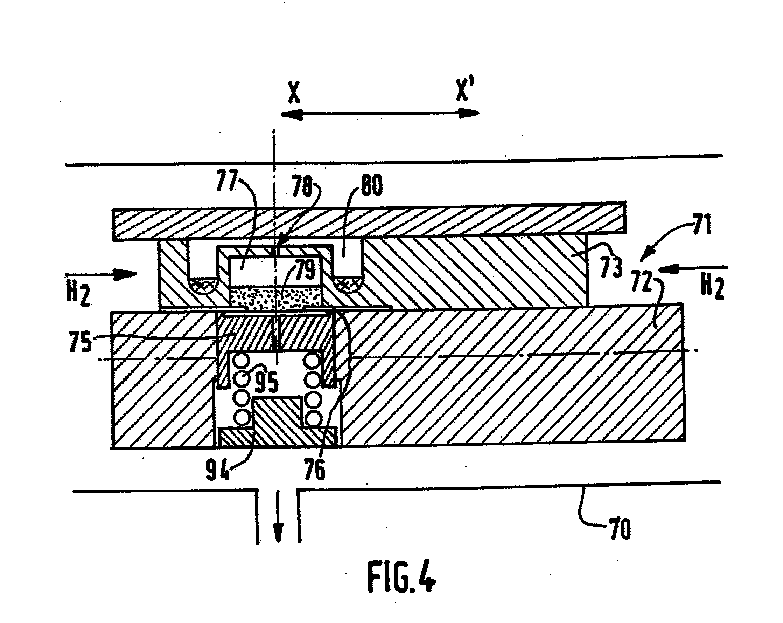

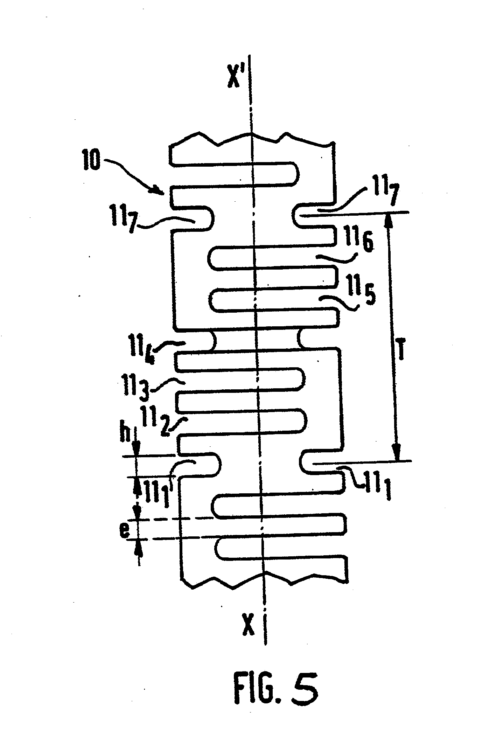

La figure 4 représente un creuset selon l'invention pour lequel la force de pression est développée par un ressort. Ce ressort 95 est monté sur un support 94 qui sert également de guide. Ce ressort pousse l'élévateur 75 et donc le substrat 76 vers le haut contre la partie mobile 73. Le chargement du substrat s'effectue par le haut, avec la partie mobile 73 enlevée. Le ressort est représenté sur la figure 5.

Sur la figure 5 est représenté un ressort 10 réalisé dans un tube cylindrique creux en quartz dans le cas d'un ressort ayant un pas à six évidements $11_1$ à $11_6$. Les évidements $11_1$ et $11_7$ sont analogues et sont distants d'un pas T. Les évidements sont espacés de $\underline{e}$ et décalés en rotation par rapport à l'axe XX' d'un angle de 360°/6 = 60° dans l'exemple représenté. La largeur de chaque évidement est $\underline{h}$.

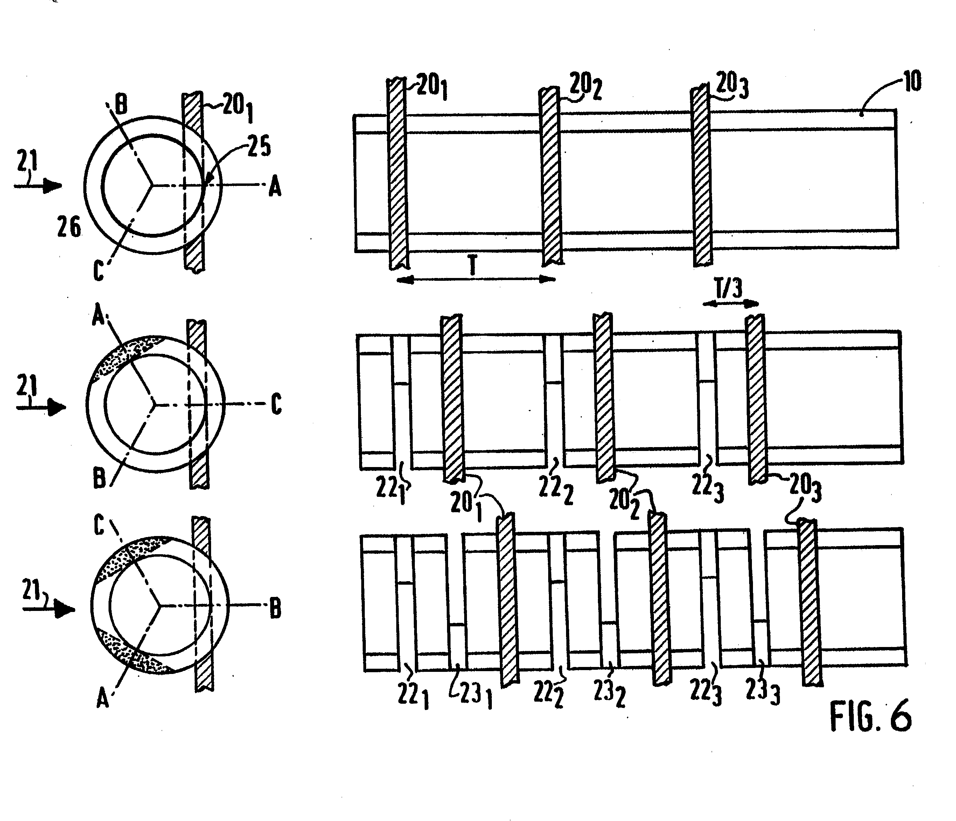

La figure 6 représente une méthode préférentielle de réalisation de l'invention dans le cas d'un pas à trois évidements pour la simplification du dessin. On utilise pour cela une scie multifils comprenant par exemple trois fils $20_1$, $20_2$, $20_3$ distants entre eux de T. La largeur des fils est sensiblement de $\underline{h}$. Trois

découpes sont effectuées $22_1$, $22_2$, $22_3$, avec le sens de pénétration représenté par la flèche 21. Les découpes sont réalisées jusqu'à ce que les fils affleurent la paroi interne 25, c'est-à-dire après avoir traversé la totalité de la zone creuse 26 du tube cylindrique.

Afin d'obtenir un pas à trois évidements le tube est alors tourné par rapport à son axe d'un angle de $360°/3 = 120°$, la position des lettres A, B, C mettant en relief cette rotation. Les trois fils sont alors déplacés selon l'axe longitudinal du tube d'une distance T/3 et trois nouveaux évidements sont réalisés $23_1$, $23_2$, $23_3$. Les opérations de rotation et de translation analogues aux précédents sont effectués puis trois autres évidements sont réalisés.

Dans le cas le plus général pour un pas comprenant $n$ évidements, le pas de rotation est de $360°/n$ et le pas de translation de chaque fils est de T/n.

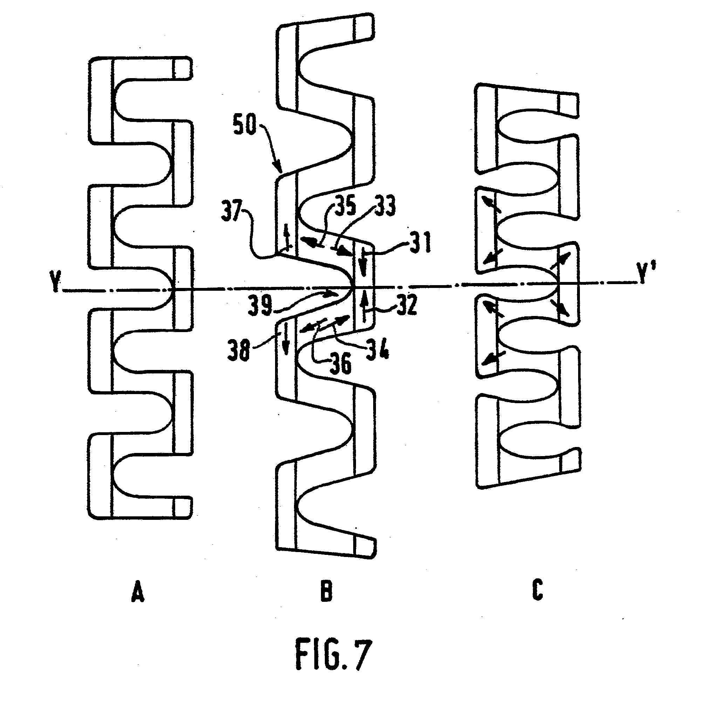

Le figure 7 représente une coupe, selon l'axe de symétrie du tube, d'un ressort selon l'invention mais repré senté pour faciliter le dessin, dans le cas d'un ressort avec un pas à deux évidements. Cette structure est très simplifiée mais permet de mieux visualiser les forces mises en oeuvre. La coupe A représente une partie de ressort au repos. En considérant des déplacements se faisant par rapport à une spire centrale centrée sur l'axe YY', on obtient en B un ressort en élongation et en C un ressort en compression. Dans ces deux cas on observe sur la spire centrale les directions des forces mises en oeuvre qui sont symétriques par rapport à l'axe YY'. Les forces représentées par les flèches 31 et 33 agissent en compression sur les forces représentées par les flèches 32 et 34. Les forces représentées par les flèches 35 et 37 agissent en extension avec les forces représentées par les flèches 36 et 38. La composition de ces forces révèle qu'une structure de ressort ayant des angles vifs est moins (bonne) qu'une structure présentant des angles arrondis. Pour cette raison le fond de chaque évidement, par exemple 39, doit préférentiellement avoir une structure arrondie. Ceci est aisément obtenu par un découpage opéré à l'aide d'une scie à fils.

Pour les mêmes raisons les bords externes de chaque évidement, tel que 50, ont préférentiellement une structure arrondie. Ceci peut être obtenu en opérant un décapage chimique local effectué après la réalisation des évidements.

La coupe C représente le même ressort dans des conditions de compression avec d'autres directions de forces mises en oeuvre. Là aussi la structure préférentielle est celle avec des angles arrondis.

Les coupes de la figure 7 représentent un exemple volontairement simplifié, mais les mêmes mécanismes d'équilibre de forces se présentent, mais de manière bien plus complexe, dans des ressorts selon l'invention pour des pas avec un nombre d'évidements supérieur à 2.

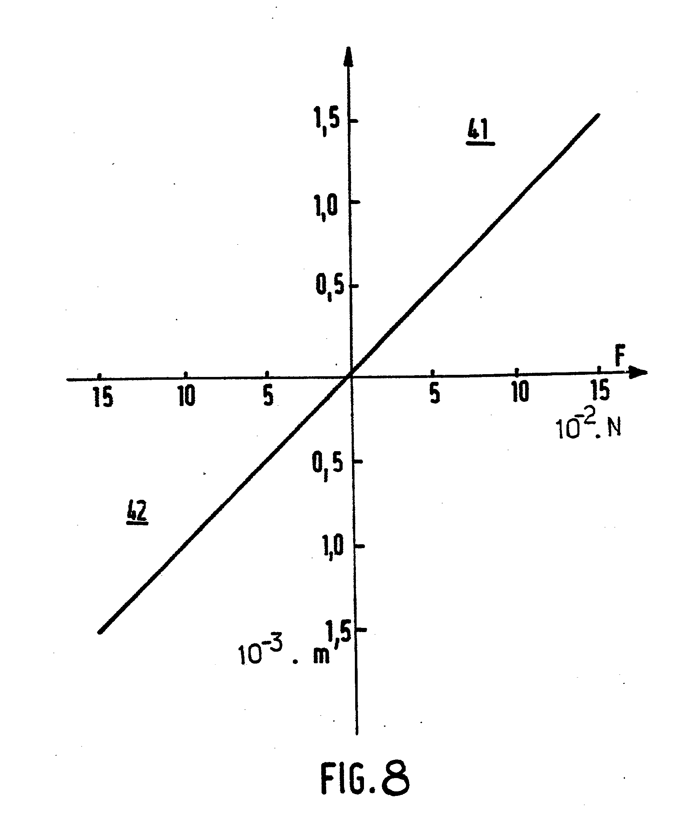

La figure 8 fournit la courbe d'élongation en compression-extension en fonction de la force appliquée pour un ressort en quartz selon l'invention. Pour un ressort ayant les caractéristiques géométriques suivantes :
. longueur : 20 mm
. nombre d'évidements : 26
. pas T = 2,25 mm
. largeur de découpe h = 0,2 mm
. distance entre découpe e = 0,548 mm
. épaisseur de la paroi du tube : 1 mm
. diamètre d = 18 mm.

La courbe d'élongation en fonction de la force est sensiblement linéaire. Sa pente est environ de $10^{-2}$ m/N. Il opère aussi bien en compression (zone 41) qu'en extension (zone 42).Ce ressort peut également supporter de faibles forces de torsion.

Les ressorts en matériau réfractaire non métallique qui viennent d'être décrits peuvent être utilisés dans les applications qui nécessitent la transmission ou l'absorption de forces de faible amplitude dans des conditions de température élevée. Un tel ressort peut être utilisé à des températures dépassant 1000°C lorsqu'il est réalisé en quartz en carbone ou en nitrure de bore en conservant ses propriétés élastiques de base.

Dans ces situations de haute température il possède en outre l'intérêt de ne pratiquement pas fournir de vapeurs soit par évaporation de son matériau constitutif, soit par dégazage des gaz absorbés, ce qui permet de l'utiliser dans des atmosphères nécessitant de bonnes conditions de propreté.

Du fait que l'élévateur 75 coulisse librement dans l'embase 72, il est possible d'utiliser des substrats 76 ayant des tolérances d'épaisseurs bien moins sévères que selon les arts antérieurs. De même, lorsque l'on désire réaliser des multicouches, les épaisseurs cumulées des couches ne perturbent pas la réalisation des couches suivantes.

Le processus de mise en oeuvre du creuset mobile est le suivant. Les proportions des produits de base Cd, Te et Hg de la solution mère sont déterminées afin d'obtenir la composition $Hg_{1-x} Cd_x$ Te recherchée selon la valeur donnée à x à une température d'équilibre donnée. Dans l'exemple cité, les masses de la solution mère sont telles que la hauteur du bain liquide est de 3 mm environ. Dans ce cas le régime hydrodynamique de la solution est stable, technique des petits bains. Cette solution est placée sur l'embase 72 et recouvertes de la partie mobile 73 de sorte qu'elle pénètre dans la cavité 77. Durant cette opération la cavité 77 se trouve à l'écart du substrat 76 qui est positionné sur l'élévateur 76. Si l'on désire contrôler l'apport d'un ou plusieurs éléments volatils, le mercure dans le cas de $Hg_{1-x} Cd_x$ Te, on place également une source de compensation, dans ce cas Hg Te, dans les réceptacles 80. Cet apport est nécessaire lorsque l'on désire contrôler finement la composition chimique de la couche de $Hg_{1-x} Cd_x$ Te. Le creuset est ensuite placé dans un four d'épitaxie vers 450°C-500°C dans un flux d'hydrogène. Lorsque le creuset atteint la température désirée, la partie mobile 73, qui contient alors les produits de base Cd, Te et Hg sous la forme d'une source mère à l'état liquide, est déplacée longitudinalement sur l'embase 72 de sorte que la source mère 79 se trouve en contact avec le substrat 76 et la croissance de la couche épitaxiale peut commercer. A la fin de l'épitaxie l'opération inverse est effectuée. La partie mobile 73 est glissée sur l'embase 72 puis l'ensemble du creuset 71 est retiré du four. La rainure placée dans la partie mobile 73 assure ainsi un parfait essuyage de la surface de la couche épitaxiale. Seules sont légèrement perturbées, et donc habituellement inutilisables, les deux parties latérales sur lesquelles portent les lèvres des rainures.La partie centrale utilisable peut alors être découpée pour former des dispositifs semiconducteurs destinés à la détection infrarouge.

Si l'on désire faire croître d'autres couches de composition différente, il est possible de placer le substrat avec sa première couche épitaxiale sur l'élévateur et d'opérer comme préalablement, les épaisseurs cumulées ne constituant pas un handicap pour ces nouvelles étapes.

Le creuset selon l'invention vient d'être décrit avec un réceptable pour contrôler la composition des couches. Il est évident que l'on peut faire croître des couches avec un bon état de surface et sans problème particulier d'épaisseur de substrat ou de couches épitaxiales sans disposer du réceptacle. En particulier la cavité 77 peut traverser alors sur tout son diamètre la totalité de la partie mobile 73.

**Revendications**

1. Creuset pour la crcissance de couches épitaxiales, de composés chimiques formés de plusieurs éléments chimiques, par la méthode d'épitaxie en phase liquide, comprenant une embase allongée sur laquelle une partie mobile glisse longitudinalement, l'embase comprenant au moins un logement dans lequel est placé un élévateur maintenu en position à l'aide d'une légère force développée par un système de pression, élévateur sur lequel est placé un substrat sur lequel se dépose au moins une couche épitaxiale, la partie mobile comprenant au moins une cavité, recevant une source mère formée de matériaux initiaux d'épitaxie, la cavité présentant, sur la face qui jouxte l'embase, une ouverture inférieure dont les dimensions sont en rapport avec les dimensions des substrats qui y sont présentés, le creuset étant destiné à être disposé dans un réacteur porté à une température d'épitaxie, caractérisé en ce que la partie mobile (73) présente sur toute sa longueur une rainure (81) longitudinale, sur la face qui glisse longitudinalement sur l'embase (72), cette rainure ayant une profondeur légèrement supérieure aux irrégularités du substrat (76) et suffisamment faible pour que la source mère (79) ne puisse passer par capillarité, et une largeur inférieure aux dimensions du substrat afin que celui-ci ne puisse y pénétrer, et en ce que le substrat est maintenu plaqué sur les bords latéraux de la rainure par l'élévateur (75).

2. Creuset selon la revendication 1, caractérisé en ce que la profondeur de la rainure est de l'ordre de 30 μm.

3. Creuset selon une des revendications 1 ou 2, caractérisé en ce que le système de pression agissant sur l'élévateur comprend un fléau (90) dissymétrique mobile autour d'un axe.

4. Creuset selon une des revendications 1 ou 2, caractérisé en ce que le système de pression agissant sur l'élévateur comprend un ressort (95) en quartz, ou en graphite ou en nitrure de bore.

**Patentansprüche**

1. Tiegel zum Züchten von Epitaxialschichten, bestehend aus chemischen Verbindungen mit mehreren chemischen Elementen, im Epitaxialverfahren mit flüßiger Phase, wobei der Tiegel eine längliche Fußfläche enthält, auf der ein beweglicher Teil sich in der Längsrichtung verschiebt, und die Fußfläche wenigstens einen Unterbringungsraum enthält, in dem ein Senkrechtförderer aufgestellt ist, der mit einer durch ein Drucksystem ausgeübten geringen Kraft in der richtigen Stellung gehalten wird, wobei auf dem Senkrechtförderer ein Substrat angebracht ist, auf dem sich wenigstens eine Epitaxialschicht absetzt, wobei der bewegliche Teil wenigstens einen Hohlraum zum Aufnehmen einer aus Epitaxieeinleitungswerkstoffen gebildeten Mutterquelle enthält, der auf der an die Fußfläche grenzenden Fläche eine Öffnung aufweist, deren Abmeßungen etwas kleiner sind als die Abmeßungen der dort vorhandenen Substrate, wobei der Tiegel zum Aufstellen in einem auf einer Epitaxietemperatur gehaltenen Reaktionsgefäß ausgelegt ist, dadurch gekennzeichnet, daß der bewegliche Teil (73) auf der ganzen Länge der in der Längsrichtung über die Flußfläche (72) gleitenden Fläche eine Längsrille (81) enthält, deren Tiefe etwas größer als die Unebenheiten des Substrats (76) und dennoch gering ist, daß die Mutterquelle (79) nicht durch Kapillarwirkung paßieren kann, und deren Breite geringer ist als die Abmeßungen des Substrats, so daß dieses Substrat nicht darin eintreten kann und vom Senkrechtförder auf die Seitenränder der Rille gelegt wird.

2. Tiegel nach Anspruch, dadurch gekennzeichnet, daß die Rillentiefe 30 μm beträgt.

3. Tiegel nach Anspruch 1 oder 2, dadurch gekennzeichnet, daß das auf den Senkrechtförderer wirkende Drucksystem einen asymmetrischen, um eine Achse bewegbaren Hebel (90) enthält.

4. Tiegel nach Anspruch 1 oder 2, dadurch gekennzeichnet, daß das auf den Senkrechtförderer wirkende Drucksystem eine Feder (95) aus Quarz, aus Graphit oder aus Bornitrit enthält.

**Claims**

1. A crucible for the growth of epitaxial layers of chemical compounds formed from several chemical elements by the method of epitaxy form the liquid phase comprising an elongate support, on which a movable part slides longitudinally, the support having at least one recess in which is placed an elevator held in position by means of a small force developed by a pressure system, on which elevator is placed a substrate, on which at least one epitaxial layer is to be deposited, the movable part having at least one cavity receiving a mother source formed by initial epitaxy materials, the cavity having on the surface adjoining the support a lower opening whose dimensions correspond to the dimensions of the substrate present therein, the crucible being intented to be disposed in a reactor brought to an epitaxy temperature, characterized in that the movable part (73) has throughout its length a longitudinal groove (81) on the surface which slides longitudinally on the support (72), this groove having a depth slightly larger than the irregularities of the substrates (76) and sufficiently small in order that the mother solution (79) cannot pass by a capillary effect and width smaller than the dimensions of the substrate in order that the latter cannot penetrate into it, and in that the substrate is held in position on the lateral edges of the groove by the elevator (75).

2. A crucible as claimed in Claim 1, characterized in that the depth of the groove is of the order of 30 μm.

3. A crucible as claimed in any one of Claims 1 and 2, characterized in that the pressure system acting upon the elevator comprises an asymmetrical lever (90) movable about an axis.

4. A crucible as claimed in any one of Claims 1 and 2, characterized in that the pressure system acting upon the element comprises a spring (95) of quartz, graphite or boron nitride.

FIG.1

FIG.2

FIG.3

FIG.4

FIG. 5

FIG. 6

FIG. 7

FIG.8